(19) Europäisches Patentamt
European Patent Office
Office européen des brevets

(11) **EP 1 811 667 A1**

(12) **DEMANDE DE BREVET EUROPEEN**

(43) Date de publication:
**25.07.2007 Bulletin 2007/30**

(51) Int Cl.:
***H03K 19/00*** *(2006.01)*

(21) Numéro de dépôt: **06026403.3**

(22) Date de dépôt: **20.12.2006**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **18.01.2006 FR 0600421**

(71) Demandeur: **STMICROELECTRONICS SA 92120 Montrouge (FR)**

(72) Inventeur: **Tailliet, François 13710 Fuveau (FR)**

(74) Mandataire: **Marchand, André OMNIPAT, 24 Place des Martyrs de la Résistance 13100 Aix-en-Provence (FR)**

(54) **Etage d'entrée de circuit intégré**

(57) L'invention concerne un étage d'entrée d'un circuit intégré, comprenant un comparateur (DAMP) pour comparer la tension d'un signal d'entrée (Vin) de l'étage d'entrée (INST3) à une tension de référence (Vref2), et fournir un signal binaire de sortie (Vout) dont la valeur dépend du résultat de la comparaison du signal d'entrée à la tension de référence. Selon l'invention, l'étage d'entrée comprend un circuit de contre réaction (FBCT) mesurant un paramètre (i) représentatif du fonctionnement du comparateur (DAMP), et élevant la tension de référence (Vref2) tant que le paramètre mesuré révèle un mauvais fonctionnement du comparateur.

Fig. 3

EP 1 811 667 A1

**Description**

La présente invention concerne les circuits intégrés et plus particulièrement les étages d'entrée des circuits intégrés logiques CMOS fournissant un signal logique en fonction d'un signal d'entrée analogique.

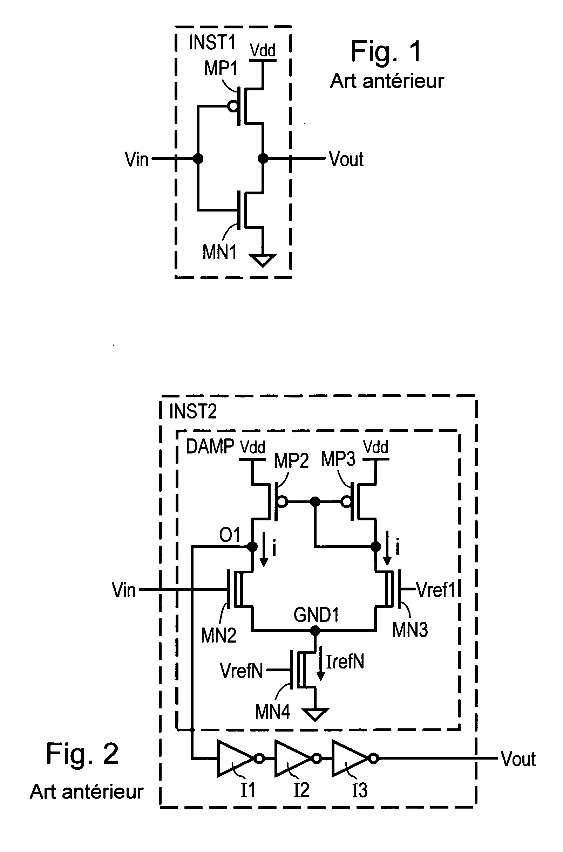

En général, les étages d'entrée des circuits intégrés comportent des entrées présentant un niveau de commutation centré autour de la moitié de la tension d'alimentation. Cette condition est facilement obtenue par exemple à l'aide de l'étage d'entrée représenté sur la figure 1. Sur la figure 1, l'étage d'entrée INST1 comporte un inverseur équilibré comprenant un transistor PMOS MP1 et un transistor NMOS MN1. La grille des transistors MP1 et MN1 est connectée à l'entrée Vin du circuit. Les drains des transistors MN1 et MP1 sont connectés à la sortie Vout du circuit. La source du transistor MP1 reçoit la tension d'alimentation Vdd. La source du transistor MN1 est connectée à la masse.

Les transistors MN1 et MP1 présentent des tensions de seuil similaires en valeur absolue. Lorsque les transistors MN1 et MP1 ont les mêmes dimensions géométriques, le transistor MN1 présente une conductance deux à trois fois plus grande que celle du transistor MP1. Cette propriété est due à la mobilité des électrons qui est deux à trois fois plus grande que celle des trous. Si le rapport largeur sur longueur W/L du transistor MP1 est deux ou trois fois plus grand que celui du transistor MN1, les deux transistors ont alors la même conductance s'ils reçoivent par ailleurs la même tension de grille-substrat en valeur absolue. En raison de sa symétrie, l'étage d'entrée INST1 présente une tension de seuil de commutation égal à la moitié de la tension d'alimentation (Vdd/2). Selon que la tension d'entrée Vin est supérieure ou inférieure à la tension de seuil de commutation, la tension du signal de sortie Vout est égale à 0 ou Vdd.

Certaines applications requièrent un seuil de commutation non pas égal à Vdd/2, mais à une autre fraction de la tension d'alimentation Vdd, ou à une tension fixe non liée à la tension Vdd. En outre, les tensions de seuil des transistors MOS à canal n et p peuvent être différentes en valeur absolue. Dans certaines applications, les étages d'entrée doivent pouvoir fonctionner à basse tension, proche des tensions de seuil des transistors du circuit intégré.

Dans de telles situations, on utilise généralement un comparateur de tension comparant la tension appliquée en entrée à une tension de référence. Typiquement, un tel comparateur est réalisé à l'aide d'un amplificateur différentiel. Un exemple d'étage d'entrée comportant un amplificateur différentiel est représenté sur la figure 2. L'étage d'entrée INST2 représenté sur la figure 2 comprend un amplificateur différentiel DAMP à miroir de courant comportant une entrée recevant la tension d'entrée Vin et une sortie O1 connectée à la sortie Vout de l'étage d'entrée INST2 par l'intermédiaire de trois inverseurs I1, I2, I3 en cascade.

Classiquement, l'amplificateur DAMP comprend une branche d'entrée recevant la tension d'entrée Vin et une branche de référence recevant une tension de référence Vref1. La branche d'entrée comprend un transistor MOS à canal p MP2 dont la source reçoit la tension d'alimentation Vdd et le drain est connecté au drain d'un transistor MOS à canal n MN2. La grille du transistor MN2 reçoit la tension d'entrée Vin. La branche de référence comprend un transistor MOS à canal p MP3 dont la source reçoit la tension d'alimentation Vdd et le drain est connecté au drain d'un transistor MOS à canal n MN3. La grille du transistor MP2 est connectée à la grille et au drain du transistor MP3.

Les sources des transistors MN2 et MN3 sont connectées au drain d'un transistor MOS à canal n MN4 dont la source est connectée à la masse. Une tension de référence VrefN est appliquée sur la grille du transistor MN4, de sorte que le courant de saturation du transistor MN4 est égal à un courant de référence IrefN. IrefN représente donc le courant maximal susceptible de traverser le transistor MN4. La sortie O1 de l'amplificateur DAMP est connectée aux drains des transistors MP2 et MN2.

Si la tension Vin est supérieure à la tension Vref1, la tension VO1 sur la sortie O1 diminue en tendant vers la tension GND1 du drain du transistor MN4. Inversement si la tension Vin est inférieure à la tension Vref1, alors la tension VO1 est égale à la tension d'alimentation Vdd. La sortie O1 fournit un signal polarisé sous un faible courant. L'inverseur I1 est réalisé avec des transistors dimensionnés pour pouvoir basculer rapidement malgré un faible courant disponible sur la sortie O1. Les rapports W/L des transistors des inverseurs I1, I2 et I3 présentent des valeurs croissantes de I1 à I3, pour mettre en forme le signal issu de la sortie O1 et fournir un signal logique sur la sortie Vout.

L'amplificateur DAMP impose certaines limitations sur la valeur de la tension de référence Vref1. En effet, l'amplificateur DAMP ne fonctionne qu'en présence d'un courant i positif suffisant dans la branche de référence (comportant les transistors MP3 et MN3). Le transistor MN3 doit donc laisser passer un courant minimum. A cet effet, la tension Vref1 doit être supérieure à la tension de seuil Vtn du transistor MN3. Pour réduire l'effet de la contrainte imposée par cette condition, on utilise de préférence des transistors à canal n natif qui présentent une plus faible tension de seuil Vtn.

En outre, si la tension Vref1 est inférieure à la tension de seuil Vtn du transistor MN3, l'étage d'entrée ne fonctionne pas du tout. La tension de sortie Vout peut alors varier d'une manière erratique, ce qui peut constituer une condition de fonctionnement dangereuse pour le circuit intégré équipé de l'étage d'entrée. Par conséquent, pour maintenir l'amplificateur DAMP dans un état pleinement opérationnel dans des conditions données de température et de tension d'alimentation, et pour une filière de fabrication donnée, la tension Vref1 doit être suffisamment plus grande que la tension de seuil Vtn du transistor MN3. Cette condition s'avère d'autant plus restrictive que les variations de la tension Vtn peuvent être totalement décorrélées des variations de la tension Vref1.

Typiquement, le transistor MN3 présente par exemple une tension de seuil Vtn à température ambiante de 450 mV, cette tension pouvant varier de +/- 100 mV selon les conditions de fabrication. Le coefficient de température, c'est-à-dire le taux de variation de la tension de seuil en fonction de la température est égal à environ -2 mV/°C. Il en résulte que dans une plage de variation de température préconisée de -40 à +85°C, la tension de seuil du transistor MN3 peut varier de 230 à 680 mV. Pour garantir le fonctionnement de l'amplificateur DAMP, la tension Vref1 doit être supérieure à 700 mV lorsque la tension de seuil Vtn du transistor MN3 atteint 680 mV. Si la tension Vref1 présente sa propre plage de variations, elle peut atteindre 1 volt.

Par ailleurs, le courant passant dans chacune des branches d'entrée et de référence doit être faible pour limiter la consommation électrique du circuit.

La présente invention vise un étage d'entrée pour circuit intégré qui ne présente pas les limitations décrites précédemment. A cet effet, une idée de la présente invention est de maintenir le transistor MN3 passant en ajustant la tension de référence.

Ainsi, un objet de l'invention est de prévoir un circuit qui mesure le courant i dans la branche de référence (transistors MP3, MN3) du comparateur et qui augmente la tension de référence pour que le courant i reste supérieur à une valeur minimum positive.

Plus particulièrement, l'invention prévoit un dispositif comprenant un comparateur pour comparer la tension d'un signal d'entrée du comparateur à une tension de référence, et fournir un signal binaire de sortie dont la valeur dépend du résultat de la comparaison du signal d'entrée à la tension de référence.

Selon l'invention, le dispositif comprend un circuit de contre réaction mesurant un paramètre représentatif du fonctionnement du comparateur, et élevant la tension de référence tant que le paramètre mesuré révèle un mauvais fonctionnement du comparateur.

Selon un mode de réalisation de l'invention, le comparateur comprend une branche d'entrée recevant le signal d'entrée et une branche de référence recevant la tension de référence, le paramètre représentatif du fonctionnement du comparateur étant un courant passant dans la branche de référence.

Selon un mode de réalisation de l'invention, le comparateur est en mauvais fonctionnement si le courant mesuré est inférieur à une valeur limite positive.

Selon un mode de réalisation de l'invention, le circuit de contre réaction comprend un étage de mesure fournissant un courant de mesure proportionnel au paramètre à mesurer, une source de tension de référence, et des moyens pour élever la tension de référence lorsque le courant de mesure est inférieur à un courant minimum.

Selon un mode de réalisation de l'invention, le circuit de contre réaction comprend une résistance pour élever l'impédance de la source de tension de référence et pour élever la tension de référence sous l'effet d'un courant traversant la résistance et apparaissant lorsque le courant mesuré est inférieur à un courant minimum.

Selon un mode de réalisation de l'invention, le circuit de contre réaction comprend un condensateur pour amortir des oscillations apparaissant dans la tension de référence.

Selon un mode de réalisation de l'invention, le comparateur comprend un premier amplificateur différentiel à miroir de courant comprenant une branche d'entrée recevant le signal d'entrée et une branche de référence recevant la tension de référence.

Selon un mode de réalisation de l'invention, le comparateur comprend plusieurs inverseurs connectés en cascade à une sortie de l'amplificateur différentiel pour mettre le signal de sortie de l'amplificateur différentiel sous la forme d'un signal logique.

Selon un mode de réalisation de l'invention, le comparateur comprend un second amplificateur différentiel connecté en cascade à une sortie du premier amplificateur, et plusieurs inverseurs montés en cascade à une sortie du second amplificateur différentiel, pour mettre le signal de sortie du premier amplificateur différentiel sous la forme d'un signal logique.

L'invention concerne également un circuit intégré comprenant un étage d'entrée, caractérisé en ce que l'étage d'entrée comprend un dispositif tel que défini ci-avant, et une entrée connectée à l'entrée du comparateur.

L'invention concerne également un procédé d'acquisition d'un signal d'entrée dans un circuit intégré, comprenant des étapes consistant à comparer la tension d'un signal d'entrée à une tension de référence, et fournir un signal binaire de sortie dont la valeur résulte de la comparaison du signal d'entrée à la tension de référence, caractérisé en ce qu'il comprend des étapes consistant à mesurer un paramètre représentatif du fonctionnement d'un comparateur ayant effectué l'étape de comparaison, et élever la tension de référence, tant que le paramètre mesuré révèle un mauvais fonctionnement du comparateur.

Selon un mode de réalisation de l'invention, le paramètre représentatif du fonctionnement du comparateur est un courant passant dans une branche de référence du comparateur.

Selon un mode de réalisation de l'invention, le comparateur est en mauvais fonctionnement si le courant mesuré est inférieur à une valeur limite positive.

Selon un mode de réalisation de l'invention, le procédé comprend des étapes consistant à fournir un courant de mesure proportionnel au paramètre à mesurer, et élever la tension de référence lorsque le courant de mesure est inférieur à un courant minimum.

Ces objets, caractéristiques et avantages ainsi que d'autres de la présente invention seront exposés plus en détail dans la description suivante d'un mode de réalisation de l'invention, faite à titre non limitatif en relation avec les figures jointes parmi lesquelles :

- la figure 1 déjà décrite représente un étage d'entrée selon l'art antérieur,
- la figure 2 déjà décrite représente un autre étage d'entrée selon l'art antérieur,
- la figure 3 représente un étage d'entrée selon l'invention,
- la figure 4 représente des courbes de tension illustrant le fonctionnement de l'étage d'entrée selon l'invention,
- la figure 5 représente une variante de réalisation d'un circuit de l'étage d'entrée selon l'invention.

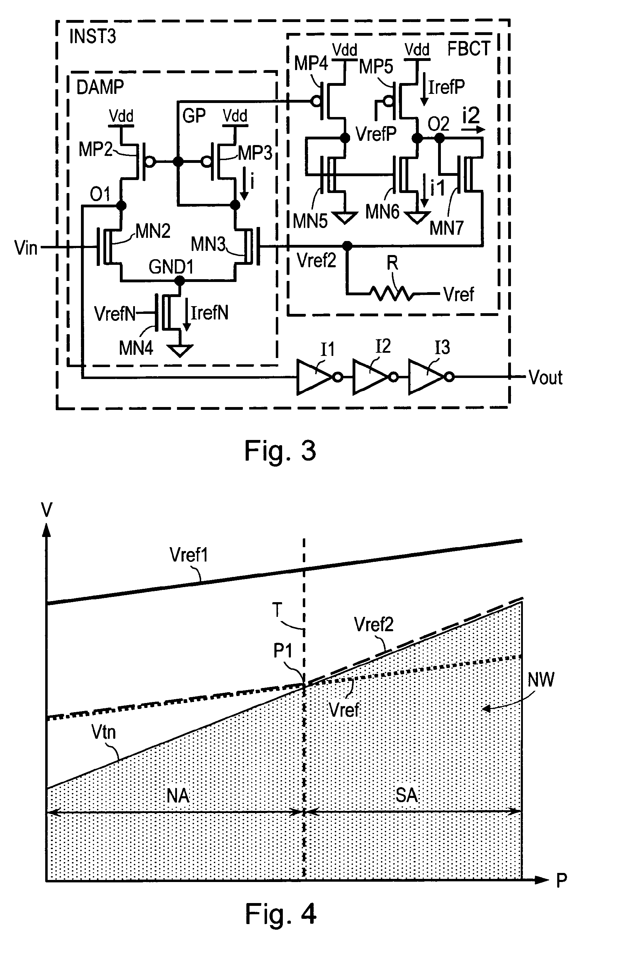

La figure 3 représente un étage d'entrée d'un circuit intégré selon l'invention. Sur la figure 3, l'étage d'entrée INST3 comprend une entrée Vin, une sortie Vout, et un comparateur pour comparer la tension appliquée à l'entrée Vin à une tension de référence Vref2. Le comparateur comprend un amplificateur différentiel DAMP connecté à l'entrée Vin de l'étage d'entrée, et trois inverseurs en cascade I1, I2, I3 connectés entre une sortie O1 de l'amplificateur DAMP et la sortie Vout de l'étage d'entrée INST3. L'amplificateur comprend une branche d'entrée Vin recevant la tension d'entrée et une branche de référence recevant la tension de référence Vref2.

Selon l'invention, l'étage d'entrée INST3 comprend un circuit de contre réaction FBCT qui ajuste la tension de référence Vref2 pour que le courant dans la branche de référence reste supérieur à une valeur minimum positive imin.

L'amplificateur DAMP est par exemple celui décrit en référence à la figure 2. Ainsi, l'amplificateur DAMP comprend une branche d'entrée recevant la tension d'entrée Vin et une branche de référence recevant une tension de référence Vref2. La branche d'entrée comprend un transistor MOS à canal p MP2 dont la source reçoit la tension d'alimentation Vdd et le drain est connecté au drain d'un transistor MOS à canal n MN2. La grille du transistor MN2 reçoit la tension d'entrée Vin. La branche de référence comprend un transistor MOS à canal p MP3 dont la source reçoit la tension d'alimentation Vdd et le drain est connecté au drain d'un transistor MOS à canal n MN3. La grille du transistor MP2 qui est à une tension GP, est connectée à la grille et au drain du transistor MP3.

Les sources des transistors MN2 et MN3 sont connectées au drain d'un transistor MOS à canal n MN4 dont la source est connectée à la masse. Une tension de référence VrefN est appliquée sur la grille du transistor MN4, de sorte qu'un courant de référence IrefN circule dans le transistor MN4. La sortie O1 de l'amplificateur DAMP est connectée aux drains des transistors MP2 et MN2. Le courant i circulant dans la branche de référence est identique à celui circulant dans la branche d'entrée si les transistors MP2 et MP3 présentent les mêmes caractéristiques physiques, et en particulier les mêmes longueur et largeur de canal.

Si la tension Vin est supérieure à la tension Vref2, la tension VO1 sur la sortie O1 diminue en tendant vers la tension GND1 du drain du transistor MN4. Inversement si la tension Vin est inférieure à la tension Vref2 alors la tension VO1 est égale à la tension d'alimentation Vdd. La sortie O1 fournit un signal polarisé sous un faible courant. L'inverseur I1 est réalisé avec des transistors dimensionnés pour pouvoir basculer rapidement malgré un faible courant disponible sur la sortie O1. Autrement dit, les transistors de l'inverseur I1 présentent de faibles largeur W et longueur L de canal pour charger capacitivement le moins possible la sortie O1, afin d'optimiser la vitesse de basculement de l'inverseur. Les rapports W/L des transistors des inverseurs I1, I2 et I3 présentent des valeurs croissantes de I1 à I3, pour mettre en forme le signal issu de la sortie O1 et fournir un signal logique sur la sortie Vout.

Si la tension GND1 est trop faible pour être compatible avec un inverseur classique, l'inverseur I1 est constitué par un amplificateur différentiel, par exemple du type de l'amplificateur DAMP.

Le circuit FBCT comprend des transistors MOS à canal p MP4, MP5 dont la source reçoit la tension d'alimentation Vdd, des transistors MOS à canal n MN5, MN6 dont la source est connectée à la masse, un transistor MOS à canal n MN7, et une résistance R. La grille du transistor MP4 reçoit la tension GP des grilles des transistors MP2 et MP3. La grille et le drain du transistor MN5 monté en diode, sont connectés au drain du transistor MP4. La grille du transistor MP5 reçoit une tension de référence VrefP, de sorte que le courant de saturation du transistor MP5 est égal à un courant de référence IrefP. Le drain du transistor MP5 est connecté au drain du transistor MN6, ainsi qu'au drain et à la grille du transistor MN7 monté en diode. La source du transistor MN7 est connectée à la grille du transistor MN3 et reliée à une source de tension de référence Vref par l'intermédiaire de la résistance R.

Les transistors NMOS de l'amplificateur DAMP et du circuit FBCT sont de préférence des transistors à canal n natif.

La tension de référence Vref2 qui est appliquée sur la grille du transistor MN3 est sensiblement égale à la tension Vref éventuellement augmentée de la tension qui apparaît sur la résistance R sous l'effet du courant i2 qui apparaît sur le drain du transistor MN7.

Le fonctionnement du circuit FBCT selon l'invention est illustré par la figure 4. La figure 4 représente sous la forme de courbes, des exemples de variations des tensions de référence Vref et Vref2, et de la tension de seuil Vtn, en fonction d'un paramètre P caractérisant l'environnement de fonctionnement du circuit intégré, à savoir notamment température de fonctionnement, tension d'alimentation, ou variation de filière de fabrication. Si la tension de référence Vref appliquée à l'amplificateur DAMP est située dans une zone NW (marquée par des pointillés sur la figure) en dessous de la courbe de variation de la tension Vtn, l'amplificateur DAMP ne fonctionne pas, le courant i passant dans le transistor MN3 étant nul. Avec les étages d'entrée de l'art antérieur tels que l'étage d'entrée INST2 illustré sur la figure 2, il était donc nécessaire de choisir une tension de référence Vref1 qui soit toujours largement supérieure à la tension de seuil Vtn, pour disposer d'une marge de sécurité vis-à-vis des variations des tensions Vref1 et Vtn. Au contraire, dans l'étage d'entrée INST3 selon l'invention, la tension de référence Vref peut être choisie à une valeur plus basse susceptible d'être située dans la zone NW.

La figure 4 représente également une droite verticale T passant par un point d'intersection P1 entre la courbe de variation de la tension Vtn et la courbe de variation de la tension Vref. La droite T délimite une zone de fonctionnement normal NA à gauche, et une zone de fonctionnement sécurisé SA à droite de la droite T.

Lorsque la tension de référence Vref est supérieure à la tension de seuil Vtn du transistor MN3 (c'est-à-dire lorsque la tension Vref est située dans la zone NA), le circuit FBCT ne modifie pas cette tension de référence (Vref2 = Vref). Par contre, lorsque la tension de référence Vref est insuffisante pour polariser l'amplificateur (Vref < Vtn) (c'est-à-dire lorsque la tension Vref est située dans la zone SA à droite de la droite T), le circuit FBCT applique à la grille du transistor MN3 de l'amplificateur DAMP une tension Vref2 égale à la tension Vref à laquelle est ajoutée la tension R.i2 (Vref2 = Vref + R.i2). La tension Vref2 est ainsi fixée à une valeur supérieure à la tension Vtn, afin que le courant i circulant dans le transistor MN3 soit supérieur à la valeur minimum fixée imin.

En pratique, le circuit FBCT mesure le courant i traversant le transistor MP2 à l'aide d'un miroir de courant comprenant le transistor MP3, et applique un courant à la résistance R si le courant i mesuré est inférieur à une certaine valeur. A cet effet, le courant qui circule dans le transistor MP3 est copié dans le transistor MN5, puis dans le transistor MN6. Le transistor MN5 tend à imposer dans le transistor MN6 un courant i1 proportionnel au courant i (= K.i). Le coefficient de proportionnalité K dépend du rapport de la chaîne miroir formée des transistors MP3, MP4, MN5 et MN6. Plus précisément, le rapport K est proportionnel au rapport WR = WMP4/WMP3.WMN6/WMN5, dans lequel WMP4, WMP3, WMN5, WMN6 sont respectivement les largeurs de canal des transistors MP4, MP3, MN5 et MN6.

Si le courant i1 dans le transistor MN6 est inférieur au courant de saturation IrefP du transistor MP5, le transistor MP5 tire davantage de courant que le transistor MN6. Il en résulte que la tension V02 augmente et donc que la tension Vref2 augmente également. Le transistor MN3 tire alors davantage de courant, et donc fait augmenter l'intensité du courant i. L'équilibre est atteint lorsque i1 (= K.i) = IrefP.

Le choix de la tension VrefP permet donc d'ajuster la valeur du courant i minimum imin positif devant circuler dans la branche de référence et dans la branche d'entrée, à l'équilibre de la boucle de contre réaction :

$$Imin = IrefP/K \qquad\qquad (1)$$

Ce choix est utile car il s'agit de trouver un compromis entre la consommation électrique et la vitesse de réaction du circuit d'entrée. Si le signal d'entrée présente une fréquence de l'ordre de quelques dizaines de kHz, le courant i doit être égal à au moins une centaine de nA. Si le signal d'entrée présente une fréquence de l'ordre de quelques MHz, le courant i doit être égal à au moins quelques $\mu$A.

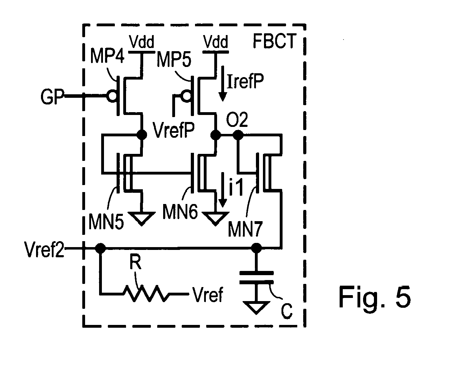

La source de tension de référence Vref présente une basse impédance. La présence de la résistance R permet à la tension Vref2 d'augmenter sous l'effet du courant i2. La valeur de la résistance R a une influence sur la boucle de contre réaction formée par le circuit FBCT. Plus la valeur de cette résistance est élevée, plus le gain de la boucle de contre-réaction formée par le circuit VTCT est élevé, ce qui tend à augmenter le risque d'apparition d'oscillations. Pour remédier à cet inconvénient, le circuit FBCT comprend, comme illustré sur la figure 5, un condensateur C permettant de stabiliser la boucle de contre-réaction. Le condensateur C peut être inséré entre le drain du transistor MN6 ou la source du transistor MN7 et la masse (figure 5).

Le courant circulant dans la branche d'entrée (transistors MP2, MN2) est sensiblement égal au courant i circulant dans la branche de référence (transistors MP3, MN3) si la tension d'entrée Vin est supérieure ou égale à la tension Vref2. Il en résulte que deux branches de l'amplificateur différentiel tendent à imposer dans le transistor MN4 un courant maximal égal à 2i. Or le courant maximal pouvant traverser le transistor MN4 est égal à son courant de saturation IrefN. Donc le courant i sera contrôlé par le circuit de contre réaction FBCT si IrefN > 2i, soit :

$$i < IrefN/2. \qquad\qquad (2)$$

Dans le cas contraire, le courant maximal serait contrôlé par le transistor MN4, et égal a IrefN/2, tandis que le circuit FBCT tendrait à imposer une tension 02 = Vdd, et donc à saturer la tension Vref2 à une tension maximale, proche de Vdd - Vtn, sans pouvoir atteindre la valeur du courant i dans le transistor MP3. La condition IrefN > 2i assure aussi que le transistor MN4 ne sera pas saturé, donc que la tension GND1 restera suffisamment faible pour que la tension O1 à l'état bas soit proche de la masse, ce qui est compatible avec l'usage de l'inverseur I1.

Comme K.i = IrefP à l'équilibre, la condition (2) est équivalente à la condition suivante :

$$IrefP < (K/2).IrefN. \qquad\qquad (3)$$

Les conditions (1) et (3) permettent donc de déterminer les valeurs à choisir de IrefP et IrefN en fonction de la valeur minimum imin souhaitable du courant i dans la branche de référence.

Le circuit FBCT qui vient d'être décrit permet de ne pas imposer une tension de référence Vref élevée, tout en respectant une marge de sécurité suffisante de fonctionnement de l'amplificateur différentiel.

Il peut être avantageux dans certaines applications de choisir une source de tension qui fournisse une tension référence Vref inférieure ou égale à la tension de seuil Vtn, de sorte que la tension de référence Vref2 qui est appliquée sur la grille du transistor MN3 soit toujours ajustée par le circuit FBCT à une valeur minimum assurant un fonctionnement correct de l'amplificateur différentiel DAMP.

Il apparaîtra clairement à l'homme de l'art que l'invention est susceptible de diverses variantes et applications. Ainsi, l'invention n'est pas limitée à une mesure de courant dans la branche de référence. On peut en effet envisager de mesurer la tension GND1 pour détecter un fonctionnement correct de l'amplificateur différentiel. Si la tension GND1 est nulle ou trop proche de la masse, le courant traversant les branches de référence et d'entrée est insuffisant.

En outre, certaines applications peuvent ne pas avoir besoin d'un signal en sortie Vout du comparateur mis en forme. Dans ce cas, les inverseurs I1, I2, I3 montés en cascade à la sortie de l'amplificateur différentiel DAMP ne sont pas nécessaires.

L'invention ne s'applique pas nécessairement à un circuit intégré. D'une manière générale, l'invention s'applique à tout dispositif devant détecter la présence de tensions qui peuvent être faibles.

**Revendications**

1.  Dispositif comprenant un comparateur (DAMP) pour comparer la tension d'un signal d'entrée du comparateur (Vin) à une tension de référence (Vref2), et fournir un signal binaire de sortie (Vout) dont la valeur dépend du résultat de la comparaison du signal d'entrée à la tension de référence,
    **caractérisé en ce qu'**il comprend un circuit de contre réaction (FBCT) mesurant un paramètre (i) représentatif du fonctionnement du comparateur (DAMP), et élevant la tension de référence (Vref2) tant que le paramètre mesuré révèle un mauvais fonctionnement du comparateur.

2.  Dispositif selon la revendication 1, dans lequel le comparateur (DAMP) comprend une branche d'entrée (MP2, MN2) recevant le signal d'entrée (Vin) et une branche de référence (MP3, MN3) recevant la tension de référence (Vref), le paramètre représentatif du fonctionnement du comparateur étant un courant (i) passant dans la branche de référence (MP3, MN3).

3.  Dispositif selon la revendication 2, dans lequel le comparateur (DAMP) est en mauvais fonctionnement si le courant mesuré (i) est inférieur à une valeur limite positive.

4.  Dispositif selon l'une des revendications 1 à 3, dans lequel le circuit de contre réaction (FBCT) comprend un étage de mesure (MP4, MN5, MP5, MN6) fournissant un courant de mesure (i1) proportionnel au paramètre (i) à mesurer, une source de tension de référence (Vref), et des moyens (R) pour élever la tension de référence (Vref2) lorsque le courant de mesure (i1) est inférieur à un courant minimum (IrefP).

5.  Dispositif selon l'une des revendications 1 à 4, dans lequel le circuit de contre réaction (FBCT) comprend une résistance (R) pour élever l'impédance de la source de tension de référence (Vref) et pour élever la tension de référence (Vref2) sous l'effet d'un courant (i2) traversant la résistance et apparaissant lorsque le courant mesuré (i) est inférieur à un courant minimum (imin).

6.  Dispositif selon l'une des revendications 1 à 5, dans lequel le circuit de contre réaction (FBCT) comprend un condensateur (C) pour amortir des oscillations apparaissant dans la tension de référence (Vref2).

**7.** Dispositif selon l'une des revendications 1 à 6, dans lequel le comparateur comprend un premier amplificateur différentiel (DAMP) à miroir de courant comprenant une branche d'entrée (MP2, MN2) recevant le signal d'entrée (Vin) et une branche de référence (MP3, MN3) recevant la tension de référence (Vref2).

**8.** Dispositif selon la revendication 7, dans lequel le comparateur comprend plusieurs inverseurs (I1, I2, I3) connectés en cascade à une sortie (O1) de l'amplificateur différentiel pour mettre le signal de sortie (VO1) de l'amplificateur différentiel sous la forme d'un signal logique.

**9.** Dispositif selon la revendication 7, dans lequel le comparateur comprend un second amplificateur différentiel (I1) connecté en cascade à une sortie (01) du premier amplificateur, et plusieurs inverseurs (I2, I3) montés en cascade à une sortie du second amplificateur différentiel, pour mettre le signal de sortie (VO1) du premier amplificateur différentiel sous la forme d'un signal logique.

**10.** Circuit intégré comprenant un étage d'entrée, **caractérisé en ce que** l'étage d'entrée (INST3) comprend un dispositif selon l'une des revendications 1 à 9, et une entrée connectée à l'entrée (Vin) du comparateur (DAMP).

**11.** Procédé d'acquisition d'un signal d'entrée dans un circuit intégré, comprenant des étapes consistant à comparer la tension d'un signal d'entrée (Vin) à une tension de référence (Vref2), et fournir un signal binaire de sortie (Vout) dont la valeur résulte de la comparaison du signal d'entrée à la tension de référence, **caractérisé en ce qu'**il comprend des étapes consistant à mesurer un paramètre (i) représentatif du fonctionnement d'un comparateur (DAMP) ayant effectué l'étape de comparaison, et élever la tension de référence (Vref2), tant que le paramètre mesuré révèle un mauvais fonctionnement du comparateur.

**12.** Procédé selon la revendication 11, dans lequel le paramètre représentatif du fonctionnement du comparateur (DAMP) est un courant passant dans une branche de référence (MP3, MN3) du comparateur.

**13.** Procédé selon la revendication 11 ou 12, dans lequel le comparateur (DAMP) est en mauvais fonctionnement si le courant mesuré (i) est inférieur à une valeur limite positive (imin).

**14.** Procédé selon l'une des revendications 11 à 13, comprenant des étapes consistant à fournir un courant de mesure (i1) proportionnel au paramètre (i) à mesurer, et élever la tension de référence (Vref2) lorsque le courant de mesure (i1) est inférieur à un courant minimum (IrefP).

Fig. 1
Art antérieur

Fig. 2
Art antérieur

Fig. 3

Fig. 4

Fig. 5

**Office européen
des brevets**

**RAPPORT DE RECHERCHE EUROPEENNE**

Numéro de la demande

EP 06 02 6403

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 5 548 227 A (MINAMI ET AL) 20 août 1996 (1996-08-20) * colonne 2, ligne 28 - colonne 4, ligne 33; figures 1,3 * ----- | 1,10,11 | INV. H03K19/00 |
| A | US 6 249 556 B1 (REES ROGER R ET AL) 19 juin 2001 (2001-06-19) * colonne 3, ligne 6 - colonne 5, ligne 2; figures 2,4 * ----- | 1-14 | |
| A | US 5 268 872 A (FUJII ET AL) 7 décembre 1993 (1993-12-07) * colonne 5, ligne 11 - colonne 6, ligne 6027; figures 1-5 * ----- | 1-14 | |
| A | US 6 249 162 B1 (INOUE KOICHI) 19 juin 2001 (2001-06-19) * colonne 3, ligne 6 - colonne 4, ligne 27; figure 3 * ----- | 1-14 | |
| A | US 5 214 328 A (OHI ET AL) 25 mai 1993 (1993-05-25) * colonne 4, ligne 43 - colonne 6, ligne 19; figures 3-5 * ----- | 1-14 | DOMAINES TECHNIQUES RECHERCHES (IPC) H03K |

Le présent rapport a été établi pour toutes les revendications

| Lieu de la recherche | Date d'achèvement de la recherche | Examinateur |
|---|---|---|
| La Haye | 20 mars 2007 | Meulemans, Bart |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

........................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 06 02 6403

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

20-03-2007

| Document brevet cité au rapport de recherche | | | Date de publication | Membre(s) de la famille de brevet(s) | | | Date de publication |
|---|---|---|---|---|---|---|---|
| US | 5548227 | A | 20-08-1996 | AU | 682229 | B2 | 25-09-1997 |
| | | | | AU | 8175994 | A | 06-07-1995 |
| | | | | CA | 2139050 | A1 | 29-06-1995 |
| | | | | CN | 1117152 | A | 21-02-1996 |
| | | | | GB | 2285316 | A | 05-07-1995 |
| | | | | JP | 2734963 | B2 | 02-04-1998 |
| | | | | JP | 7198760 | A | 01-08-1995 |
| | | | | TW | 382080 | B | 11-02-2000 |
| US | 6249556 | B1 | 19-06-2001 | AUCUN | | | |
| US | 5268872 | A | 07-12-1993 | JP | 4297119 | A | 21-10-1992 |
| US | 6249162 | B1 | 19-06-2001 | JP | 6324092 | A | 25-11-1994 |
| US | 5214328 | A | 25-05-1993 | JP | 2855802 | B2 | 10-02-1999 |
| | | | | JP | 4057513 | A | 25-02-1992 |

EPO FORM P0460

Pour tout renseignement concernant cette annexe : voir Journal Officiel de l'Office européen des brevets, No.12/82